(19)

**Europäisches Patentamt**
**European Patent Office**
**Office européen des brevets**

(11) **EP 4 726 332 A2**

(12) **EUROPÄISCHE PATENTANMELDUNG**

(43) Veröffentlichungstag:
**15.04.2026   Patentblatt 2026/16**

(21) Anmeldenummer: **25207085.9**

(22) Anmeldetag: **07.10.2025**

(51) Internationale Patentklassifikation (IPC):
**G01D 5/14** $^{(2006.01)}$        **G01R 33/02** $^{(2006.01)}$
**G01R 33/025** $^{(2006.01)}$      **B23K 11/25** $^{(2006.01)}$

(52) Gemeinsame Patentklassifikation (CPC):
**B23K 11/253; G01D 5/14; G01R 33/0206;
G01R 33/025**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH LA MA MD TN**

(30) Priorität: **11.10.2024   DE 102024129376**

(71) Anmelder: **SICK AG
79183 Waldkirch (DE)**

(72) Erfinder: **BLUDAU, Thomas
79211 Denzlingen (DE)**

(74) Vertreter: **Manitz Finsterwald
Patent- und Rechtsanwaltspartnerschaft mbB
Martin-Greif-Straße 1
80336 München (DE)**

(54) **VORRICHTUNG ZUR DURCHFÜHRUNG EINER ARBEITSOPERATION**

(57)   Die Erfindung betrifft eine Vorrichtung zur Durchführung einer Arbeitsoperation, insbesondere Schweißvorrichtung, umfassend: zumindest einen Aktor, der die Arbeitsoperation ausführt; eine an dem Aktor befestigte Magnetfeldquelle; zumindest einen Magnetfeldsensor zur Erfassung der Position des Aktors, wobei der Magnetfeldsensor ausgebildet ist, eine erste Magnetfeldstärke in eine erste Richtung und eine zweite Magnetfeldstärke in eine zweite, zur ersten Richtung senkrechte Richtung zu erfassen; und eine Steuer- und Auswerteeinheit, die mit dem Magnetfeldsensor verbunden ist und dazu ausgebildet ist, basierend auf einer Vergleichsmetrik, welche die erfasste erste Magnetfeldstärke in Bezug zu der erfassten zweiten Magnetfeldstärke setzt, zu identifizieren, ob es sich bei dem von dem Magnetfeldsensor erfassten Magnetfeld um ein im Wesentlichen von der Magnetfeldquelle erzeugtes Magnetfeld handelt, und bei einer positiven Feststellung basierend auf der erfassten ersten Magnetfeldstärke und/oder der erfassten zweiten Magnetfeldstärke eine Position des Aktors zu ermitteln und basierend auf der ermittelten Position des Aktors eine Steueranweisung auszugeben.

Fig. 2

**Beschreibung**

Magnetfeldsensoren, wie beispielsweise magnetische Endlagenschalter, finden in einer Vielzahl von Anwendungen Einsatz, um die Position, insbesondere eine Endposition, eines Aktors innerhalb der Anwendung zu bestimmen. Solche Anwendungen sind häufig mit pneumatischen Zylindern, Greifern oder ähnlichen Aktoren ausgestattet, deren Endposition mit Hilfe von magnetischen Endlagenschaltern erfasst wird. Die Endlagenschalter basieren auf der Detektion eines Magnetfeldes, das von einem Gebermagneten im Aktor erzeugt wird.

In der Praxis kann es jedoch zu Problemen kommen, da magnetische Störfelder, welche in der Regel einen räumlich statischen Ursprung haben, den magnetischen Endlagenschalter stören und Fehlschaltungen verursachen können. Bei Schweißanwendungen können beispielsweise durch die beim Schweißvorgang erzeugten hohen Stromstärken starke Magnetfelder erzeugt werden, die als magnetische Störfelder wirken. Die durch diese magnetischen Störfelder hervorgerufenen Fehlfunktionen sind unerwünscht, da sie die genaue Erfassung der Aktorposition beeinträchtigen und die Zuverlässigkeit des Systems gefährden.

Bestehende Ansätze zur Lösung dieses Problems sind oftmals aufwendig und führen zu einer erhöhten Komplexität oder können die unerwünschten Fehlfunktionen nicht in zufriedenstellendem Ausmaß verhindern.

Es ist eine Aufgabe der vorliegenden Erfindung, eine verbesserte Vorrichtung zur Durchführung einer Arbeitsoperation sowie ein entsprechendes Verfahren bereitzustellen.

Diese Aufgabe wird durch eine Vorrichtung gemäß Anspruch 1 sowie ein Verfahren gemäß Anspruch 11 gelöst.

Ein erster Aspekt der Erfindung betrifft eine Vorrichtung zur Durchführung einer Arbeitsoperation, insbesondere Schweißvorrichtung, umfassend:

zumindest einen Aktor, der die Arbeitsoperation ausführt,
eine an dem Aktor befestigte Magnetfeldquelle,
zumindest einen Magnetfeldsensor zur Erfassung der Position des Aktors, wobei der Magnetfeldsensor ausgebildet ist, eine erste Magnetfeldstärke in eine erste Richtung und eine zweite Magnetfeldstärke in eine zweite, zur ersten Richtung senkrechte Richtung zu erfassen,
eine Steuer- und Auswerteeinheit, die mit dem Magnetfeldsensor verbunden ist und dazu ausgebildet ist, basierend auf einer Vergleichsmetrik, welche die erfasste erste Magnetfeldstärke in Bezug zu der erfassten zweiten Magnetfeldstärke setzt, zu identifizieren, ob es sich bei dem von dem Magnetfeldsensor erfassten Magnetfeld um ein im Wesentlichen von der Magnetfeldquelle erzeugtes Magnetfeld handelt, und
bei einer positiven Feststellung basierend auf der erfassten ersten Magnetfeldstärke und/oder der erfassten zweiten Magnetfeldstärke eine Position des Aktors zu ermitteln und basierend auf der ermittelten Position des Aktors eine Steueranweisung auszugeben.

Die Erfindung geht von dem Grundgedanken aus, dass ein von der Magnetfeldquelle, welche an dem Aktor befestigt ist, erzeugtes Magnetfeld spezifische Eigenschaften aufweist, welche sich von anderen Störmagnetfeldern unterscheiden. Insbesondere bewegt sich die Magnetfeldquelle durch die Bewegungen des Aktors relativ zu dem Magnetfeldsensor, was sich in sich unterschiedlich verändernden ersten und zweiten Magnetfeldstärken niederschlägt. Andere, sich nicht bewegende Erzeuger von Magnetfeldern, beispielsweise eine Schweißvorrichtung, können erfindungsgemäß von der am Aktor befestigten Magnetfeldquelle unterschieden werden.

Beispielswiese ist die Magnetfeldquelle ein Permanentmagnet, dessen magnetische Eigenschaften bekannt sind. Die Magnetfeldquelle kann aber auch ein Elektromagnet, insbesondere mit einem vorgegebenen Pulsmuster, sein. Das Magnetfeld der Magnetfeldquelle könnte dementsprechend zusätzlich auch durch das Pulsmuster erkannt und/oder verifiziert werden.

Es ist also möglich, bei den von dem Magnetfeldsensor erfassten Magnetfelddaten, d.h. der erfassten ersten Magnetfeldstärke und der erfassten zweiten Magnetfeldstärke, zu prüfen, ob diese tatsächlich von der zu erfassenden am Aktor befestigten Magnetfeldquelle stammen und nicht durch ein Störmagnetfeld verursacht werden. Nur wenn diese Bedingung erfüllt ist, wird basierend auf den Sensordaten des Magnetfeldsensors die Position des Aktors ermittelt bzw. wird festgestellt, dass die ermittelte Position des Aktors valide ist und damit der tatsächlichen Position des Aktors entspricht. Insbesondere wird bei einer negativen Feststellung, d.h. wenn die Steuer- und Auswerteeinheit feststellt, dass es sich bei dem von dem Magnetfeldsensor erfassten Magnetfeld nicht um ein von der Magnetfeldquelle erzeugtes Magnetfeld handelt, keine Steueranweisung ausgegeben. Somit kann eine Fehlfunktion der Vorrichtung, beispielsweise ein Stoppen des Aktors aufgrund einer fehlerhaft ermittelten Position des Aktors, verhindert werden.

Die Störmagnetfelder werden in vielen Anwendungen im Rahmen der Durchführung der Arbeitsoperation verursacht bzw. erzeugt. Ein Beispiel hierfür ist das durch die hohen Ströme beim Schweißen verursachte Magnetfeld bei einer Schweißvorrichtung. In diesem Fall kann der Aktor beispielsweise eine Schweißzange sein, welche relativ zu einem Werkstück beweglich ist und beispielsweise ein vorgegebenes Bewegungsmuster bzw. einen vorgegebenen Bewegungsradius aufweist. Andere Anwendungen sind beispielsweise magnetische Hebevorrichtungen oder Linearmotorsysteme, bei denen ebenfalls derartige Störmagnetfelder entstehen können, welche von dem Magnetfeldsensor fälschlicherweise als ein von der zu erfassenden Magnetfeldquelle erzeugtes Magnetfeld wahrgenommen werden können.

Die Quelle von Störmagnetfeldern kann, insbesondere relativ zu dem Magnetfeldsensor, ortsfest sein. Dies bedeutet, dass z.B. die genannte Schweißvorrichtung oder die Hebevorrichtung dauerhaft ortsfest angeordnet ist. Beispielsweise kann es sich um eine stationäre Schweißvorrichtung handeln, welcher durch den Aktor zu bearbeitende Werkstücke zugeführt werden. Alternativ kann die Quelle der Störmagnetfelder auch nur in derem Betrieb, d.h. während der Erzeugung des Störmagnetfelds, ortsfest sein. Beispielsweise kann die Quelle der Störmagnetfelder eine an dem Aktor befestigte Schweißzange sein, welche beim Schweißen aber nicht bewegt wird (und z.B. an einem Werkstück anliegt).

Der Magnetfeldsensor erfasst eine erste Magnetfeldstärke in eine erste Richtung und eine zweite Magnetfeldstärke in eine zweite, zur ersten Richtung senkrechte Richtung. Bei der erfassten Magnetfeldstärke kann es sich beispielsweise um eine magnetische Flussdichte handeln. Basierend auf der erfassten ersten Magnetfeldstärke und der erfassten zweiten Magnetfeldstärke kann der Magnetfeldsensor eine Position der an dem Aktor befestigten Magnetfeldquelle und damit des Aktors ermitteln. Insbesondere kann die Position der Magnetfeldquelle bzw. des Aktors relativ zum Magnetfeldsensor ermittelt werden. Da die Position des Magnetfeldsensors, insbesondere innerhalb der Vorrichtung, bekannt ist, kann somit auf die absolute Position der Magnetfeldquelle im Raum mittels bekannter mathematischer Modelle geschlossen werden. Insbesondere kann die erfasste erste Magnetfeldstärke und die erfasste zweite Magnetfeldstärke, beispielsweise mittels einer Zuordnungstabelle, einer Position im Raum zugeordnet werden. Die Erfassung der Position einer Magnetfeldquelle mittels eines Magnetfeldsensors ist aus dem Stand der Technik bekannt, so dass hierin nicht weiter dazu ausgeführt wird.

Um eine zuvor beschriebene Fehldetektion zu verhindern, wird eine Vergleichsmetrik ermittelt, welche die erfasste erste Magnetfeldstärke in Bezug zu der erfassten zweiten Magnetfeldstärke setzt. Ein durch die Magnetfeldquelle erzeugtes Magnetfeld führt dabei zu entsprechenden kennzeichnenden Werten der Vergleichsmetrik. Gleiches gilt für die Störmagnetfelder. Diese jeweiligen kennzeichnenden Wertebereiche sind beispielsweise bekannt, sodass die Vergleichsmetrik anzeigen kann, ob es sich bei dem erfassten Magnetfeld um ein im Wesentlichen von der Magnetfeldquelle erzeugtes Magnetfeld handelt oder nicht. Aus der Vergleichsmetrik kann insbesondere abgeleitet werden, ob es sich bei der erfassten Position des Aktors um eine tatsächliche Position des Aktors handelt.

Ein Vorteil der Erfindung liegt darin, dass für die Identifizierung, ob es sich bei dem von dem Magnetfeldsensor erfassten Magnetfeld um ein von der Magnetfeldquelle erzeugtes Magnetfeld handelt, neben dem Magnetfeldsensor selbst keine zusätzlichen Bauteile notwendig sind, sondern die Bestimmung auf Basis der erfassten Daten erfolgt. Die Bestimmung ist somit auf einfache Weise und ohne zusätzliche Kosten für entsprechende Hardware möglich. Ein weiterer Vorteil dieser datenbasierten Lösung liegt darin, dass kein zusätzlicher Platz für entsprechende Bauteile notwendig ist, so dass die Vorrichtung und insbesondere die Sensorik besonders kompakt ausgebildet ist.

Weitere Ausführungsformen der Erfindung sind der Beschreibung, den Unteransprüchen und den Zeichnungen zu entnehmen.

Gemäß einer ersten Ausführungsform ist die Steuer- und Auswerteeinheit ausgebildet, basierend auf der Vergleichsmetrik festzustellen, ob das erfasste Magnetfeld ein Magnetfeld mit räumlich statischem Ursprung oder ein Magnetfeld mit räumlich veränderlichem Ursprung ist, und bei einer Feststellung, dass das Magnetfeld ein Magnetfeld mit räumlich veränderlichem Ursprung ist, das von dem Magnetfeldsensor erfasste Magnetfeld als ein von der Magnetfeldquelle erzeugtes Magnetfeld zu identifizieren. Es wird also der Umstand ausgenutzt, dass die Magnetfeldquelle am Aktor befestigt ist und sich somit die räumliche Position der Magnetfeldquelle verändern kann. Eine Magnetfeldquelle, welche ihre Raumposition beispielsweise aufgrund einer Aktorbewegung verändern kann, führt zu Magnetfeldvektoren mit veränderlichem Winkel und veränderlichem Betrag. Im Vergleich hierzu sind die Störmagnetfelder in der Regel räumlich statische Magnetfelder, die von einem festen Punkt im Raum ausgehen und sich insbesondere nur über die Zeit verändern. Sowohl ein räumlich statisches als auch ein räumlich veränderliches Magnetfeld können somit dazu führen, dass der Magnetfeldsensor über einen Erfassungszeitraum sich verändernde Magnetfelddaten bzw. Magnetfeldstärken erfasst. Im Unterschied zur Magnetfeldquelle mit räumlich statischem Ursprung kann sich jedoch bei der Magnetfeldquelle mit räumlich veränderlichem Ursprung die Raumrichtung der Magnetfeldvektoren über den Erfassungszeitraum verändern. Dieser Unterschied kann in der Vergleichsmetrik abgebildet und somit basierend auf der Vergleichsmetrik mittels der Steuer- und Auswerteeinheit detektiert werden.

Gemäß einer Ausführungsform ist die Steuer- und Auswerteeinheit ausgebildet, basierend auf der Vergleichsmetrik festzustellen, ob das erfasste Magnetfeld von einem zeitlich statischen oder von einem zeitlich veränderlichen Magnetfeld ausgeht, und bei einer Feststellung, dass das erfasste Magnetfeld von einem zeitlich statischen Magnetfeld ausgeht, das von dem Magnetfeldsensor erfasste Magnetfeld als ein von der Magnetfeldquelle erzeugtes Magnetfeld zu identifizieren. Wie bereits vorstehend beschrieben, können sich die von dem Magnetfeldsensor erfassten Magnetfeldstärken sowohl für eine räumlich statische Magnetfeldquelle als auch für eine räumlich veränderliche Magnetfeldquelle über den Erfassungszeitraum verändern. Gehen die erfassten Magnetfeldstärken von einem zeitlich veränderlichen Magnetfeld mit räumlich statischem Ursprung aus, sind die über den Erfassungszeitraum erfassten Veränderungen der Magnetfeldstärke für die erfasste erste Magnetfeldstärke und für die erfasste zweite Magnetfeldstärke gleichartig, insbesondere proportional, da die über den Erfassungszeitraum erfassten Änderungen der Magnetfeldstärke die gleiche Ursache aufweisen, beispielsweise die Erhöhung des Stroms während eines Schweißvorgangs. Im Gegensatz dazu wirkt sich bei einer Magnetfeldquelle, welche ein zeitlich statisches Magnetfeld aufweist, sich jedoch in ihrer räumlichen Position verändert, die Veränderung der Raumposition der Magnetfeldquelle über den Erfassungszeitraum nicht gleichartig auf die erfasste erste Magnetfeldstärke in die erste Richtung und die erfasste zweite Magnetfeldstärke in die zweite Richtung aus. Dies ist insbesondere dadurch begründet, dass eine Änderung der Raumposition der Magnetfeldquelle die erfasste erste Magnetfeldstärke stärker beeinflusst als die erfasste zweite Magnetfeldstärke.

Gemäß einer Ausführungsform ist die Steuer- und Auswerteeinheit ausgebildet, basierend auf den Sensordaten des Magnetfeldsensors zu ermitteln, ob der Aktor eine Endposition erreicht hat. Beispielsweise kann die Endposition des Aktors vorgegeben sein. Wenn der Aktor und somit die Magnetfeldquelle die Endposition erreichen, sollte der Magnetfeldsensor eine dieser Endposition zugehörige erste Magnetfeldstärke in die erste Richtung und eine zugehörige zweite Magnetfeldstärke in die zweite Richtung erfassen. Die der Endposition zugehörige erste Magnetfeldstärke und die der Endposition zugehörige zweite Magnetfeldstärke können beispielsweise bekannt sein, so dass basierend auf einem Vergleich der erfassten ersten Magnetfeldstärke und der erfassten zweiten Magnetfeldstärke mit der der Endposition zugehörigen ersten Magnetfeldstärke und der der Endposition zugehörigen zweiten Magnetfeldstärke ermittelt werden kann, ob der Aktor die Endposition erreicht hat. Insbesondere kann sich die Positionsbestimmung des Aktors auf eine Bestimmung der Endposition des Aktors beschränken, d.h. der Magnetfeldsensor wird einzig dafür genutzt, zu ermitteln, ob der Aktor eine Endposition erreicht hat. In diesem Fall ist die Ermittlung, ob es sich bei dem von dem Magnetfeldsensor erfassten Magnetfeld um ein von der Magnetfeldquelle erzeugtes Magnetfeld handelt, besonders einfach, da ein von der Magnetfeldquelle erzeugtes Magnetfeld entsprechenden Einschränkungen unterliegt und somit die Unterscheidung zwischen einem Magnetfeld, welches von der Magnetfeldquelle erzeugt wird, und einem Magnetfeld, welches von einem Störmagnetfeld erzeugt wird, vereinfacht wird.

Gemäß einer Ausführungsform ist die Steuer- und Auswerteeinheit ausgebildet, die erfasste erste Magnetfeldstärke und die erfasste zweite Magnetfeldstärke auf Basis derselben vorgegebenen Normierungsregel zu normieren, wobei die Vergleichsmetrik die normierte erfasste erste Magnetfeldstärke in Bezug zu der normierten erfassten zweiten Magnetfeldstärke setzt. Wie bereits vorher beschrieben, entwickelt sich die Magnetfeldstärke bei einer räumlich statischen Magnetfeldquelle, welche jedoch eine zeitlich veränderliche Magnetfeldstärke aufweisen kann, proportional für die erste Magnetfeldstärke und die zweite Magnetfeldstärke. Bei einer räumlich veränderlichen Magnetfeldquelle ist dies nicht der Fall. Unter Ausnutzung dieser Erkenntnis kann eine entsprechende Normierungsregel festgelegt werden, mit der die erfasste erste Magnetfeldstärke und die erfasste zweite Magnetfeldstärke normiert werden, um diesen proportionalen Effekt auf die erste Magnetfeldstärke und die zweite Magnetfeldstärke zu kompensieren. Für ein zeitlich veränderliches Magnetfeld mit räumlich statischem Ursprung führt die Anwendung dieser Normierungsregel dazu, dass die normierten erfassten Magnetfeldstärken, d.h. die normierte erfasste erste Magnetfeldstärke und die normierte erfasste zweite Magnetfeldstärke, über den Erfassungszeitraum im Wesentlichen identisch sind. Mit anderen Worten, sind die erfassten normierten Magnetfeldverläufe der ersten Magnetfeldstärke und der zweiten Magnetfeldstärke deckungsgleich. Die Anwendung der gleichen Normierungsregel auf die erfassten Magnetfeldstärken, welche von einem zeitlich statischen Magnetfeld mit räumlich veränderlichem Ursprung ausgehen, führt hingegen nicht dazu, dass die erfassten Magnetfeldstärken im Wesentlichen identisch sind, d.h. die entsprechenden erfassten normierten Magnetfeldverläufe sind nicht deckungsgleich. Die Veränderung der erfassten Magnetfeldstärken ergibt sich in diesem Fall nämlich aus der Veränderung der Position der Magnetfeldquelle, welche in die erste und zweite Richtung in der Regel nicht proportional ist. Somit kann insbesondere basierend auf einem Unterschied zwischen der normierten erfassten ersten Magnetfeldstärke und der normierten erfassten zweiten Magnetfeldstärke ermittelt werden, ob es sich bei dem von dem Magnetfeldsensor erfassten Magnetfeld um ein von der Magnetfeldquelle erzeugtes Magnetfeld handelt.

Die Normierung der erfassten ersten Magnetfeldstärke und der erfassten zweiten Magnetfeldstärke kann beispielsweise dadurch erfolgen, dass die jeweilige erfasste Magnetfeldstärke mittels eines jeweiligen Normierungsfaktors multipliziert wird, welcher auf Basis der vorgegebenen Normierungsregel berechnet wird. Die Normierung hat insbesondere den Effekt, dass ein absoluter Betrag der jeweiligen erfassten Magnetfeldstärke und/oder eine über die Zeit proportionale Änderung der jeweiligen erfassten Magnetfeldstärke kompensiert wird.

Der Normierungsfaktor kann beispielsweise wie folgt berechnet werden:

$$Normierungsfaktor = \frac{2}{(MaxWert - MinWert) + (StoppWert - StartWert)}$$

wobei der MaxWert bzw. MinWert dem über den Erfassungszeitraum erfassten Maximalwert bzw. Minimalwert der jeweiligen Magnetfeldstärke entspricht und der StartWert bzw. StoppWert dem über den Erfassungszeitraum erfassten ersten Wert bzw. letzten Wert der jeweiligen Magnetfeldstärke entspricht. Der Normierungsfaktor wird also für eine zugehörige Magnetfeldstärke, d.h. die erste oder zweite Magnetfeldstärke, basierend auf den erfassten Werten für die zugehörige Magnetfeldstärke berechnet. Der für eine jeweilige Magnetfeldstärke berechnete Normierungsfaktor kann anschließend mit allen erfassten Werten der jeweiligen Magnetfeldstärke multipliziert werden, um die jeweilige normierte Magnetfeldstärke zu erhalten.

Die normierten Werte für die erfasste erste Magnetfeldstärke und die erfasste zweite Magnetfeldstärke befinden sich für den vorstehenden Normierungsfaktor in einem Bereich zwischen 0 und 2. Die Erfindung ist jedoch nicht beschränkt auf den vorstehenden Normierungsfaktor. Vielmehr kann jeder geeignete Normierungsfaktor verwendet werden. Weitere Beispiele für einen entsprechenden Normierungsfaktor sind:

$$Normierungsfaktor(i) = abs\left(\frac{Magnetstärke(i) - Startwert}{MaxWert - MinWert}\right)$$

$$Normierungsfaktor(i) = \left(\frac{Magnetstärke(i) - Startwert}{StoppWert - StartWert}\right)$$

wobei hier der Normierungsfaktor für jeden erfassten Magnetstärkenwert separat berechnet wird. Anders ausgedrückt, wird der *Normierungsfaktor(i)* für die erfasste Magnetstärke zum Zeitpunkt i, d.h. für die *Magnetstärke(i),* mit der zugehörigen *Magnetstärke(i)* multipliziert, um die jeweilige normierte Magnetfeldstärke zu erhalten.

Die vorstehenden Normierungsfaktoren sind rein beispielhaft und die Erfindung ist nicht auf diese begrenzt. Insbesondere kann jede geeignete Normierungsregel verwendet werden.

Gemäß einer Ausführungsform basiert die Vergleichsmetrik auf einer Differenz zwischen dem größeren Wert aus der normierten erfassten ersten Magnetfeldstärke und der normierten erfassten zweiten Magnetfeldstärke und dem kleineren Wert aus der normierten erfassten ersten Magnetfeldstärke und der normierten erfassten zweiten Magnetfeldstärke. Wie bereits vorher beschrieben, kann die Ermittlung, ob es sich bei dem von dem Magnetfeldsensor erfassten Magnetfeld um ein von der Magnetfeldquelle erzeugtes Magnetfeld handelt, basierend auf einem Unterschied zwischen der normierten erfassten ersten Magnetfeldstärke und der normierten erfassten zweiten Magnetfeldstärke erfolgen. Um die Zuverlässigkeit und Aussagekraft dieser Ermittlung zu erhöhen, kann die Vergleichsmetrik insbesondere basierend auf dem maximalen Unterschied zwischen den beiden jeweiligen Magnetfeldstärken ermittelt werden. Beispielsweise kann die Vergleichsmetrik für den Zeitpunkt i des Erfassungszeitraums auf Basis der folgenden Gleichung ermittelt werden:

*Vergleichsmetrik(i) =*

*Max(Normwerte(X(i)), Normwert(Y(i))) – Min(Normwerte(X(i)), Normwert(Y(i)))*

wobei X(i) bzw. Y(i) die zum Zeitpunkt i erfasste erste Magnetfeldstärke in die erste Richtung bzw. die zum Zeitpunkt i erfasste zweite Magnetfeldstärke in die zweite Richtung repräsentiert. Zur finalen Evaluierung, ob es sich bei dem von dem Magnetfeldsensor erfassten Magnetfeld um ein von der Magnetfeldquelle erzeugtes Magnetfeld handelt, kann der Maximalwert der berechneten Vergleichsmetrikwerte für i=0 bis i=n verwendet werden, wobei n dem Zeitpunkt des letzten erfassten Wertes entspricht. Es wird also der größte berechnete Vergleichsmetrikwert für die finale Evaluierung verwendet, da dieser dem maximalen Unterschied zwischen der normierten erfassten ersten Magnetfeldstärke und der normierten erfassten zweiten Magnetfeldstärke entspricht. Basierend auf diesem maximalen Unterschied kann insbesondere ermittelt werden, ob die Normierung eine über die Zeit in beide Richtungen proportionale Veränderung der Magnetfeldstärke kompensieren konnte und damit das entsprechende Magnetfeld von einer räumlich statischen Magnetfeldquelle ausging oder ob die Veränderung der ersten und zweiten Magnetfeldstärke über den Erfassungszeitraum nicht proportional sind und damit das entsprechende Magnetfeld von einer räumlich veränderlichen Magnetfeldquelle ausging.

Gemäß einer Ausführungsform umfasst die Vorrichtung mehrere, insbesondere zwei, Magnetfeldsensoren. Beispielsweise kann die Vorrichtung einen ersten Magnetfeldsensor umfassen, der eine erste Magnetfeldstärke in eine erste Richtung erfasst, und einen zweiten Magnetfeldsensor, der eine zweite Magnetfeldstärke in eine zweite, zur ersten Richtung senkrechte Richtung erfasst. Der erste und zweite Magnetfeldsensor sind dabei insbesondere an unterschiedlichen Positionen angeordnet. Die erste Magnetfeldstärke und die zweite Magnetfeldstärke werden somit von unterschiedlichen Magnetfeldsensoren erfasst. Alternativ kann der erste Magnetfeldsensor als auch der zweite Magnetfeldsensor eine Magnetfeldstärke in eine erste Richtung und in eine zweite, zur ersten Richtung senkrechte Richtung erfassen. Diese Konfiguration hat den Vorteil, dass zusätzliche Informationen vorliegen, mit denen die Magnetfeldaktivität besser bewertet werden kann.

Es ist auch denkbar, dass die Schweißvorrichtung mehrere Aktoren umfasst, an welchen jeweils eine Magnetfeldquelle befestigt ist, sodass die Position der jeweiligen Aktoren erfasst werden kann.

**EP 4 726 332 A2**

Gemäß einer Ausführungsform basiert die Vergleichsmetrik auf der Differenz zwischen der von einem ersten Magnetfeldsensor normierten erfassten ersten Magnetfeldstärke in die erste Richtung und der von einem zweiten Magnetfeldsensor erfassten ersten Magnetfeldstärke in die erste Richtung oder auf der Differenz zwischen der von einem ersten Magnetfeldsensor normierten erfassten zweiten Magnetfeldstärke in die zweite Richtung und der von einem zweiten Magnetfeldsensor normierten erfassten zweiten Magnetfeldstärke in die zweite Richtung. Insbesondere kann die jeweilige Differenz eine Differenz der über den Erfassungszeitraum erfassten Maximalwerte der jeweiligen Magnetfeldstärke umfassen. Beispielsweise kann die Vergleichsmetrik auf Basis der folgenden Gleichung ermittelt werden:

$$Vergleichsmetrik =$$

$$Min(Max(abs(X_1-X_2)), Max(abs(Y_1-Y_2)))$$

wobei $X_1$ die über den Erfassungszeitraum von dem ersten Magnetfeldsensor erfassten Magnetstärken in die erste Richtung umfasst, $X_2$ die über den Erfassungszeitraum von dem zweiten Magnetfeldsensor erfassten Magnetstärken in die erste Richtung umfasst, $Y_1$ die über den Erfassungszeitraum von dem ersten Magnetfeldsensor erfassten Magnetstärken in die zweite Richtung umfasst und $Y_2$ die über den Erfassungszeitraum von dem zweiten Magnetfeldsensor erfassten Magnetstärken in die zweite Richtung umfasst. Mit anderen Worten, wird Differenz zwischen der Funktion $X_1$ und $X_2$ sowie $Y_1$ und $Y_2$ gebildet und der Maximalwert der jeweiligen Differenzfunktion ermittelt. Anschließend wird der kleinere der beiden berechneten Maximalwerte als Vergleichsmetrik verwendet.

Gemäß einer Ausführungsform basiert die Vergleichsmetrik auf der Differenz zwischen zwei aus der folgenden Auswahl: Die von dem ersten Magnetfeldsensor normierte erfasste Magnetfeldstärke in die erste Richtung, die von dem ersten Magnetfeldsensor normierte erfasste Magnetfeldstärke in die zweite Richtung, die von dem zweiten Magnetfeldsensor normierte erfasste Magnetfeldstärke in die erste Richtung und die von dem zweiten Magnetfeldsensor normierte erfasste Magnetfeldstärke in die zweite Richtung; wobei die Auswahl der zwei Magnetfeldstärken für die Bildung der Differenz basierend darauf erfolgt, welche der normierten erfassten Magnetfeldstärken für den Erfassungszeitraum die größte Differenz zwischen Minimalwert und Maximalwert aufweisen, wobei der Minimalwert der über den Erfassungszeitraum kleinste ermittelte Wert für die jeweilige Magnetfeldstärke ist und der Maximalwert der über den Erfassungszeitraum größte ermittelte Wert für die jeweilige Magnetfeldstärke ist. Insbesondere kann die jeweilige Differenz eine Differenz der über den Erfassungszeitraum erfassten Maximalwerte der jeweiligen Magnetfeldstärke umfassen. Mit anderen Worten werden die beiden Magnetfeldstärken für die Bildung der Differenz verwendet, welche über den Erfassungszeitraum die größte Abweichung zwischen erfasstem Minimalwert und erfasstem Maximalwert aufweisen. Die Vergleichsmetrik kann beispielsweise wie folgt ermittelt werden:

$$Vergleichsmetrik = Max(abs(Z_1-Z_2))$$

wobei $Z_1$ und $Z_2$ den normierten erfassten Magnetfeldstärken entsprechen, die für den Erfassungszeitraum die größte Differenz zwischen Minimalwert und Maximalwert aufweisen, wobei der Minimalwert der über den Erfassungszeitraum kleinste ermittelte Wert für die jeweilige Magnetfeldstärke ist und der Maximalwert der über den Erfassungszeitraum größte ermittelte Wert für die jeweilige Magnetfeldstärke ist.

Ein weiterer Aspekt der Erfindung bezieht sich auf ein Verfahren zur Durchführung einer Arbeitsoperation, insbesondere eines Schweißvorgangs, wobei das Verfahren umfasst, dass:

von zumindest einem Magnetfeldsensor zur Erfassung der Position zumindest eines Aktors, an dem eine Magnetfeldquelle befestigt ist, eine erste Magnetfeldstärke in eine erste Richtung und eine zweite Magnetfeldstärke in eine zweite, zur ersten Richtung senkrechte Richtung erfasst wird,
von einer Steuer- und Auswerteeinheit, die mit dem Magnetfeldsensor verbunden ist, basierend auf einer Vergleichsmetrik, welche die erfasste erste Magnetfeldstärke in Bezug zu der erfassten zweiten Magnetfeldstärke setzt, identifiziert wird, ob es sich bei dem von dem Magnetfeldsensor erfassten Magnetfeld um ein von der Magnetfeldquelle erzeugtes Magnetfeld handelt, und
bei einer positiven Feststellung basierend auf der erfassten ersten Magnetfeldstärke und/oder der erfassten zweiten Magnetfeldstärke eine Position des Aktors ermittelt wird und basierend auf der ermittelten Position des Aktors eine Steueranweisung ausgegeben wird.

Für das Verfahren gelten die Ausführungen zu der erfindungsgemäßen Vorrichtung entsprechend, dies gilt insbesondere hinsichtlich Vorteilen und Ausführungsformen.
Es ist zu beachten, dass jede Kombination der vorstehenden Ausführungsformen möglich ist, so lange dies nicht explizit ausgeschlossen wurde.

Nachfolgend wird die Erfindung rein beispielhaft unter Bezugnahme auf die Zeichnungen dargestellt. Es zeigen:

Fig. 1 eine schematische Darstellung einer Schweißvorrichtung;

Fig. 2 eine schematische Darstellung einer weiteren Schweißvorrichtung;

Fig. 3 durch einen ersten Magnetfeldsensor und einen zweiten Magnetfeldsensor erfasste Magnetfeldstärken in eine erste Richtung und in eine zweite, zur ersten Richtung senkrechte Richtung für Schweißvorgänge mit unterschiedlichen Sensor-zu-Schweißzange-Positionskonfigurationen;

Fig. 4 die normierten Magnetfeldstärken der in Fig. 3 dargestellten Magnetfeldstärken;

Fig. 5 durch einen ersten Magnetfeldsensor und einen zweiten Magnetfeldsensor erfasste Magnetfeldstärken in eine erste Richtung und in eine zweite, zur ersten Richtung senkrechte Richtung für Aktorbewegungen mit unterschiedlichen Sensor-zu-Schweißzange-Positionskonfigurationen;

Fig. 6 die normierten Magnetfeldstärken der in Fig. 5 dargestellten Magnetfeldstärken; und

Fig. 7 die von einem ersten Magnetfeldsensor und einem zweiten Magnetfeldsensor erfassten Magnetfeldstärken in eine X-Richtung und in eine Y-Richtung, welche orthogonal zur X-Richtung ist, für unterschiedliche Positionen eines Gebermagneten.

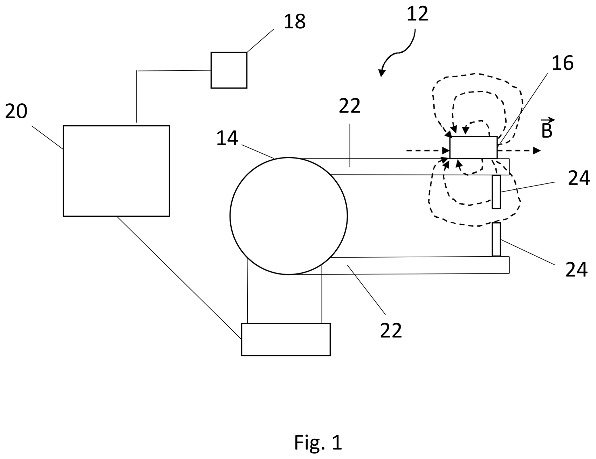

Fig. 1 zeigt eine schematische Darstellung einer Schweißvorrichtung 12 zur Durchführung eines Schweißvorgangs. Die Schweißvorrichtung 12 umfasst einen Aktor, hier eine Schweißzange 14, die dazu ausgebildet ist, die Arbeitsoperation, d.h. den Schweißvorgang, auszuführen, und einen an der Schweißzange 14 befestigten Permanentmagneten, welcher als Gebermagnet 16 fungiert. Ferner umfasst die Schweißvorrichtung 12 zumindest einen Magnetfeldsensor 18 zur Erfassung der Position der Schweißzange 14, wobei der Magnetfeldsensor 18 ausgebildet ist, eine erste Magnetfeldstärke in eine erste Richtung und eine zweite Magnetfeldstärke in eine zweite, zur ersten Richtung senkrechte Richtung zu erfassen, sowie eine Steuer- und Auswerteeinheit 20, die mit dem Magnetfeldsensor 18 verbunden ist und dazu ausgebildet ist, basierend auf einer Vergleichsmetrik, welche die erfasste erste Magnetfeldstärke in Bezug zu der erfassten zweiten Magnetfeldstärke setzt, zu identifizieren, ob es sich bei dem von dem Magnetfeldsensor 18 erfassten Magnetfeld um ein im Wesentlichen von dem Gebermagnet 16 erzeugtes Magnetfeld handelt, und bei einer positiven Feststellung basierend auf der erfassten ersten Magnetfeldstärke und/oder der erfassten zweiten Magnetfeldstärke eine Position der Schweißzange 14 zu ermitteln und basierend auf der ermittelten Position der Schweißzange 14 eine Steueranweisung auszugeben.

Die Schweißvorrichtung 12 kann beispielsweise in industriellen Punktschweißverfahren verwendet werden, um zwei Metallteile durch Anwendung von Druck und Strom miteinander zu verbinden. Beispielsweise wird die Schweißvorrichtung 12 in der Automobilproduktion, im Stahlbau und in anderen industriellen Fertigungsprozessen verwendet. Die Schweißzange 14 umfasst zwei Elektrodenarme 22 mit jeweiligen Elektroden 24 an den Enden der Elektrodenarme 22, wobei die Elektrodenarme 22 dazu verwendet werden, um zwei Metallteile, welche in Fig. 1 nicht gezeigte sind, fest zusammenzudrücken und an den Berührungspunkten Schweißstrom durch die Werkstücke zu leiten. Die Elektroden 24 an den Enden der Elektrodenarme 22 bestehen aus einem Material mit hoher Leitfähigkeit, beispielsweise einer Kupferlegierung, um den elektrischen Strom effizient zu leiten und gleichzeitig widerstandsfähig gegen die Hitze zu sein, die beim Schweißen entsteht. Durch den angelegten Strom wird das Metall an den Kontaktpunkten erhitzt, sodass es lokal schmilzt und sich eine feste Schweißverbindung bilden kann. An einem der Elektrodenarme 22 ist dabei der Gebermagnet 16 befestigt, sodass basierend auf der Position des entsprechenden Elektrodenarms 22 eine Position bzw. Stellung der Schweißzange 14 ermittelt werden kann. Die Schweißzange kann insbesondere eine geschlossene Stellung, wie in Fig. 1 gezeigt, sowie eine geöffnete Stellung (nicht gezeigt) annehmen. Für eine geöffnete (End-)Position der Schweißzange 14 können beispielsweise entsprechende Soll-Magnetfelddaten für die erste Magnetfeldstärke und die zweite Magnetfeldstärke gespeichert sein. Wenn die von dem Magnetfeldsensor 18 erfassten Ist-Magnetfelddaten mit den hinterlegten Soll-Magnetfelddaten übereinstimmen, kann die Steuer- und Auswerteeinheit 20 feststellen, dass sich die Schweißzange 14 in der geöffneten Position befindet. Entsprechendes gilt für die geschlossene Position und/oder für Zwischenpositionen der Schweißzange 14.

Ein Problem bei der Ermittlung der Position der Schweißzange 14 ergibt sich jedoch durch die durch die hohen Ströme beim Schweißen erzeugten Magnetfelder, welche bei der Erfassung der Position der Schweißzange 14 als Störmagnetfelder wirken. Die Störmagnetfelder werden ebenfalls von dem Magnetfeldsensor 18 erfasst, sodass hier eine Unterscheidung zwischen Störmagnetfeld und ein durch den Gebermagneten 16 erzeugtes Magnetfeld notwendig ist, damit die Steuer- und Auswerteeinheit 20 die Position der Schweißzange 14 nicht fehlerhafterweise aufgrund eines erfassten Störmagnetfelds ermittelt. Um eine fehlerhafte Erfassung der Position der Schweißzange 14 zu verhindern, wird eine Vergleichsmetrik ermittelt, welche die erfasste erste Magnetfeldstärke in Bezug zu der erfassten zweiten Magnetfeldstärke setzt, und basierend auf der Vergleichsmetrik identifiziert, ob es sich bei dem von dem Magnetfeldsensor 18 erfassten Magnetfeld um ein im Wesentlichen von dem Gebermagnet 16 erzeugtes Magnetfeld handelt oder nicht. Nur bei einer positiven Feststellung wird basierend auf der erfassten ersten Magnetfeldstärke und/oder der erfassten zweiten Magnetfeldstärke eine Position der Schweißzange 14 ermittelt.

Bei der Unterscheidung zwischen Störmagnetfeld und ein durch den Gebermagneten 16 erzeugtes Magnetfeld wird der Umstand ausgenutzt, dass der Gebermagneten 16 an dem Elektrodenarm 22 der Schweißzange 14 befestigt ist und sich somit die räumliche Position des Gebermagneten 16 durch die Bewegung des Elektrodenarms 22 verändern kann. Ein Gebermagnet 16, welche seine Raumposition beispielsweise aufgrund der Bewegung des Elektrodenarms 22 verändern kann, führt zu Magnetfeldvektoren mit veränderlichem Winkel und veränderlichem Betrag. Im Vergleich dazu ist das durch die Schweißströme erzeugte Störmagnetfeld ein Magnetfeld mit räumlich statischem Ursprung, das von einem festen Punkt im Raum ausgeht und sich nur über die Zeit verändert. Sowohl ein Magnetfeld mit räumlich statischem als auch räumlich veränderlichem Ursprung können somit dazu führen, dass der Magnetfeldsensor über einen Erfassungszeitraum sich verändernde Magnetfelddaten bzw. Magnetfeldstärken erfasst. Im Unterschied zum Magnetfeld mit räumlich statischem Ursprung kann sich jedoch bei dem Magnetfeld mit räumlich veränderlichem Ursprung die Raumrichtung der Magnetfeldvektoren über den Erfassungszeitraum verändern.

Dieser Unterschied kann basierend auf den erfassten Magnetfelddaten festgestellt werden. Gehen die erfassten Magnetfeldstärken von einem zeitlich veränderlichen Magnetfeld mit räumlich statischem Ursprung aus, sind die über den Erfassungszeitraum erfassten Veränderungen der Magnetfeldstärke für die erfasste erste Magnetfeldstärke und für die erfasste zweite Magnetfeldstärke proportional, da die über den Erfassungszeitraum erfassten Änderungen der Magnetfeldstärke die gleiche Ursache aufweisen, vorliegend die Erhöhung bzw. Reduzierung des Stroms während eines Schweißvorgangs.

Die erfasste erste Magnetfeldstärke und die erfasste zweite Magnetfeldstärke werden hierzu auf Basis derselben vorgegebenen Normierungsregel normiert und die Vergleichsmetrik auf Basis der normierten erfassten ersten Magnetfeldstärke und der normierten erfassten zweiten Magnetfeldstärke ermittelt. Wie bereits vorher beschrieben, entwickelt sich die Magnetfeldstärke bei einer räumlich statischen Magnetfeldquelle, welche jedoch eine zeitlich veränderliche Magnetfeldstärke aufweist, proportional für die erste Magnetfeldstärke und die zweite Magnetfeldstärke. Bei einer räumlich veränderlichen Magnetfeldquelle ist dies nicht der Fall. Unter Ausnutzung dieser Erkenntnis kann eine entsprechende Normierungsregel festgelegt werden, mit der die erfasste erste Magnetfeldstärke und die erfasste zweite Magnetfeldstärke normiert werden, um diesen proportionalen Effekt auf die erste Magnetfeldstärke und die zweite Magnetfeldstärke zu kompensieren. Für ein zeitlich veränderliches Magnetfeld mit räumlich statischem Ursprung führt die Anwendung dieser Normierungsregel dazu, dass die normierten erfassten Magnetfeldstärken, d.h. die normierte erfasste erste Magnetfeldstärke und die normierte erfasste zweite Magnetfeldstärke, über den Erfassungszeitraum im Wesentlichen identisch sind. Mit anderen Worten, sind die erfassten normierten Magnetfeldverläufe der ersten Magnetfeldstärke und der zweiten Magnetfeldstärke deckungsgleich. Die Anwendung der gleichen Normierungsregel auf die erfassten Magnetfeldstärken, welche von dem Gebermagneten ausgehen, d.h. einem zeitlich statischen Magnetfeld mit räumlich veränderlichem Ursprung, führt hingegen nicht dazu, dass die erfassten Magnetfeldstärken im Wesentlichen identisch sind, d.h. die entsprechenden erfassten normierten Magnetfeldverläufe sind nicht deckungsgleich. Die Veränderung der erfassten Magnetfeldstärken ergibt sich in diesem Fall nämlich aus der Veränderung der Position des Gebermagneten 16, welche in die erste und zweite Richtung in der Regel nicht proportional ist. Somit kann insbesondere basierend auf einem Unterschied zwischen der normierten erfassten ersten Magnetfeldstärke und der normierten erfassten zweiten Magnetfeldstärke ermittelt werden, ob es sich bei dem von dem Magnetfeldsensor erfassten Magnetfeld um ein von dem Gebermagneten 16 erzeugtes Magnetfeld handelt.

Die Normierung der erfassten ersten Magnetfeldstärke und der erfassten zweiten Magnetfeldstärke erfolgt insbesondere dadurch, dass die jeweilige erfasste Magnetfeldstärke mittels eines jeweiligen Normierungsfaktors multipliziert wird, welcher auf Basis der vorgegebenen Normierungsregel berechnet wird.

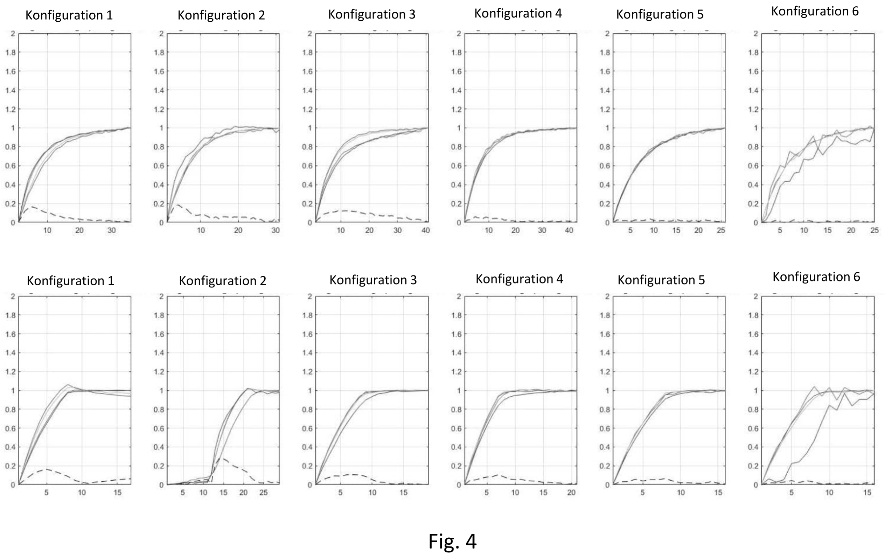

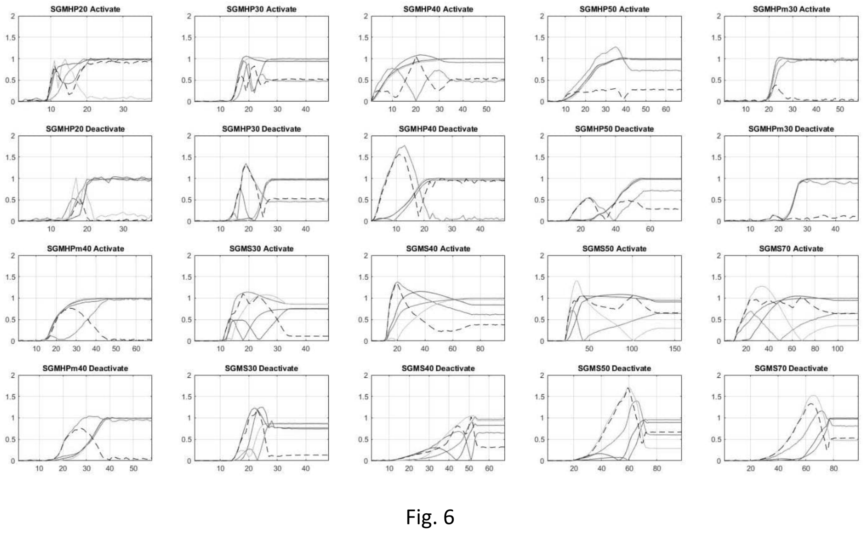

Die in Fig. 4 und 6 dargestellten normierten Magnetfeldverläufe wurden beispielsweise mit dem folgenden Normierungsfaktor multipliziert:

$$Normierungsfaktor = \frac{2}{(MaxWert - MinWert) + (StoppWert - StartWert)}$$

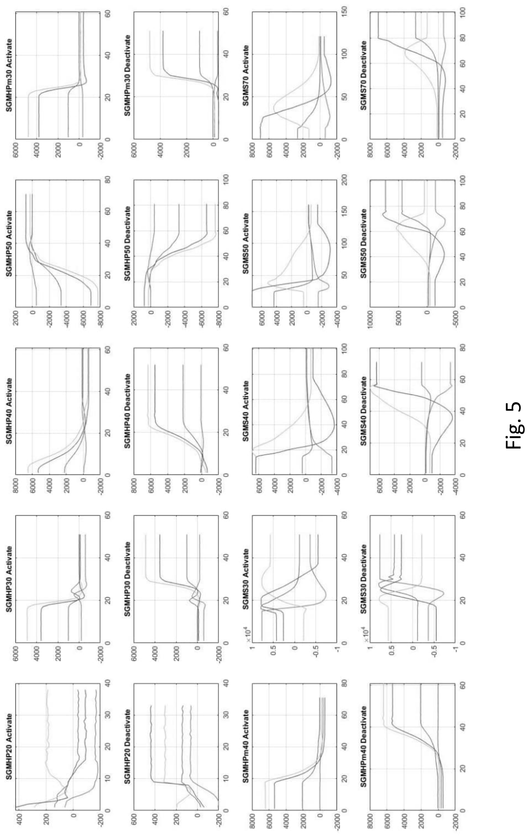

wobei der MaxWert bzw. MinWert dem über den Erfassungszeitraum erfassten Maximalwert bzw. Minimalwert der jeweiligen Magnetfeldstärke entspricht und der StartWert bzw. StoppWert dem über den Erfassungszeitraum erfassten ersten Wert bzw. letzten Wert der jeweiligen Magnetfeldstärke entspricht. Der in Fig. 4 und 5 gezeigte Verlauf der Vergleichsmetrik ergibt sich ferner wie folgt:

$$Vergleichsmetrik(i) =$$

$$Max(Normwerte(X_1(i)), Normwert(X_2(i)), Normwert(Y_1(i)), Normwert(Y_2(i))) -$$

$$Min(Normwerte(X_1(i)), Normwert(X_2(i)), Normwert(Y_1(i)), Normwert(Y_2(i)))$$

wobei $X_1(i)$ bzw. $Y_1(i)$ die zum Zeitpunkt i von einem ersten Magnetfeldsensor erfasste erste Magnetfeldstärke in die erste Richtung bzw. zweite Magnetfeldstärke in die zweite Richtung repräsentiert und $X_2(i)$ bzw. $Y_2(i)$ die zum Zeitpunkt i von einem zweiten Magnetfeldsensor erfasste erste Magnetfeldstärke in die erste Richtung bzw. zweite Magnetfeldstärke in die zweite Richtung repräsentiert.

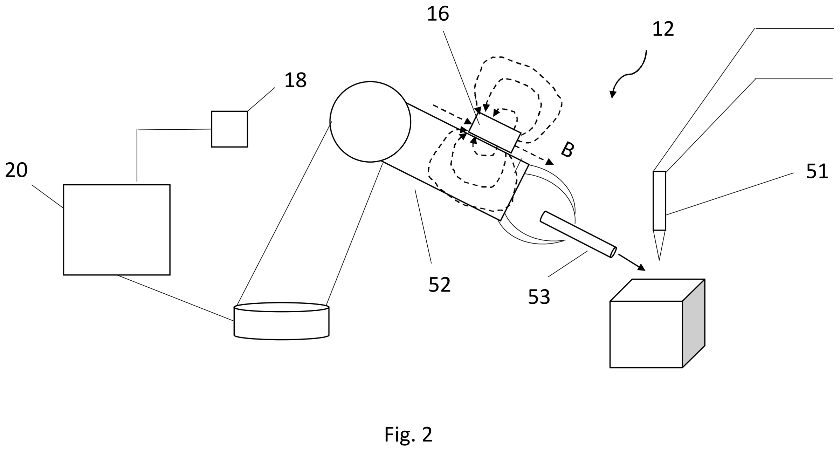

Fig. 2 eine schematische Darstellung einer weiteren Schweißvorrichtung. Anders als in Fig. 1 sind der Aktor und die Schweißmaschine 51 in Fig. 2 als separate Vorrichtungen ausgebildet. Der Aktor ist in Fig. 2 ein Werkstückträger 52, z.B. ein Roboterarm, zum Halten und Bewegen des Werkstücks 53, während die Schweißmaschine 51 als eigene Vorrichtung an einer, insbesondere ortsfesten, Position eine Schweißung des Werkstücks 53 durchführt, nachdem der Werkstückträger 52 das Werkstück 53 an die hierfür vorgesehene Position gebracht hat. Die Schweißung erfolgt somit stets an derselben Stelle. Die Ermittlung, ob es sich bei dem von dem Magnetfeldsensor 18 erfassten Magnetfeld um ein von dem Gebermagneten 16 erzeugtes Magnetfeld handelt, kann wie vorstehend beschrieben erfolgen. Insbesondere kann die Ermittlung gemäß dieser Ausführung einfacher sein, da der Werkstückträger 52 und die Schweißmaschine 51 separat ausgebildet sind und somit das durch die Schweißung erzeugte Magnetfeld und das von dem Gebermagneten 16 ausgehende Magnetfeld vollständig voneinander entkoppelt sind.

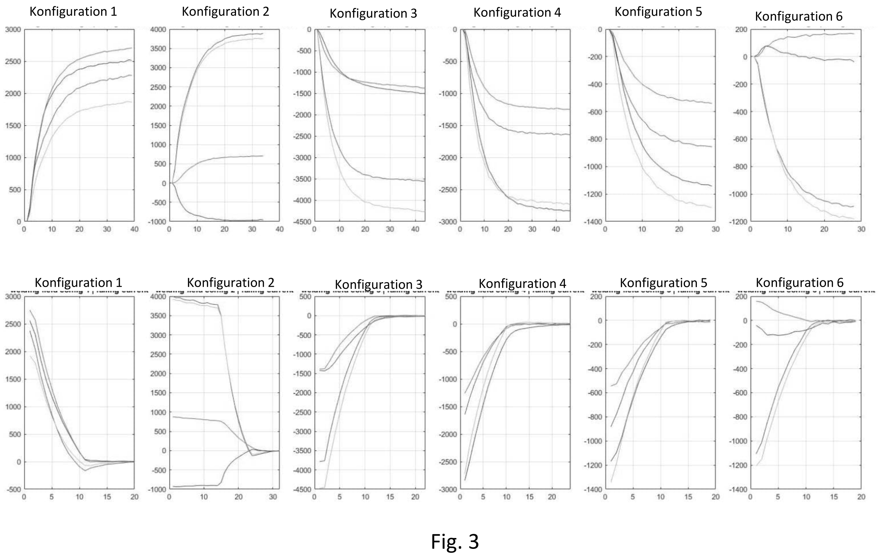

Fig. 3 zeigt die durch einen ersten Magnetfeldsensor und einen zweiten Magnetfeldsensor erfassten Magnetfeldstärken in eine erste Richtung und in eine zweite, zur ersten Richtung senkrechte Richtung für Schweißvorgänge mit unterschiedlichen Sensor-zu-Schweißzange-Positionskonfigurationen. Die Schweißvorrichtung 12 umfasst in diesem Fall also zwei Magnetfeldsensoren 18. Die obere Reihe zeigt dabei die erfassten Magnetfeldstärken für den Beginn eines Schweißvorgangs, während die untere Reihe die erfassten Magnetfeldstärken für das Beenden eines Schweißvorgangs zeigt. Zwei Graphen derselben Spalte bzw. zwei übereinanderstehende Graphen sind dabei derselben Sensor-zu-Schweißzange-Positionskonfiguration zugehörig.

Fig. 4 zeigt die auf Basis des vorstehenden Normierungsfaktors normierten Magnetfeldstärken der in Fig. 3 dargestellten Magnetfeldstärken sowie einen Verlauf der basierend auf den normierten Magnetfeldstärken ermittelten Vergleichsmetrik. Wie in Fig. 4 zu erkennen ist, liegen die Werte der normierten Magnetfeldstärken zwischen 0 und 2. Ferner ist der Wert, insbesondere der Maximalwert, der Vergleichsmetrik grundsätzlich nahe bei 0 für den gesamten Erfassungszeitraum.

Fig. 5 zeigt durch einen ersten Magnetfeldsensor und einen zweiten Magnetfeldsensor erfasste Magnetfeldstärken in eine erste Richtung und in eine zweite, zur ersten Richtung senkrechte Richtung für Bewegungen der Schweißzange mit unterschiedlichen Sensor-zu-Schweißzange-Positionskonfigurationen und unterschiedlichen Magnetisierungsstärken des Gebermagneten. Ein jeweiliger Graph zeigt dabei die durch den ersten Magnetfeldsensor und den zweiten Magnetfeldsensor erfassten Magnetfeldstärken in die erste und zweite Richtung für eine spezifische Sensor-zu-Schweißzange-Positionskonfiguration und eine spezifische Magnetisierungsstärke des Gebermagneten während eines Aktivierungsvorgangs, d.h. eines Schließvorgangs, der Schweißzange oder eines Deaktivierungsvorgangs, d.h. eines Öffnungsvorgangs, der Schweißzange.

Fig. 6 zeigt die auf Basis des vorstehenden Normierungsfaktors normierten Magnetfeldstärken der in Fig. 5 dargestellten Magnetfeldstärken sowie einen Verlauf der basierend auf den normierten Magnetfeldstärken ermittelten Vergleichsmetrik. Wie in Fig. 6 zu erkennen ist, liegen die Werte der normierten Magnetfeldstärken wie bereits bei den in Fig. 4 normierten Magnetfeldverläufen zwischen 0 und 2. Ferner ist der Wert, insbesondere der Maximalwert, der Vergleichsmetrik für einen Großteil des Erfassungszeitraums deutlich von 0 verschieden.

Wie aus den Figuren 4 und 6 ersichtlich, fällt der Maximalwert der Vergleichsmetrik für ein durch einen Schweißvorgang erzeugtes Störmagnetfeld deutlich kleiner aus als der Maximalwert der Vergleichsmetrik für ein durch den Gebermagneten 16 erzeugtes Magnetfeld. Somit kann durch Festlegung eines geeigneten Schwellenwerts für den Maximalwert der Vergleichsmetrik für ein erfasstes Magnetfeld auf einfache Weise ermittelt werden, ob es sich um ein durch einen Schweißvorgang erzeugtes Störmagnetfeld oder ein durch den Gebermagneten 16 erzeugtes Magnetfeld handelt. Beispielsweise kann bei einer Überschreitung des Schwellenwert festgestellt werden, dass es sich bei dem erfassten Magnetfeld um ein durch den Gebermagneten 16 erzeugtes Magnetfeld handelt, und bei einer Unterschreitung des Schwellenwerts festgestellt werden, dass es sich bei dem erfassten Magnetfeld um ein durch einen Schweißvorgang erzeugtes Störmagnetfeld handelt.

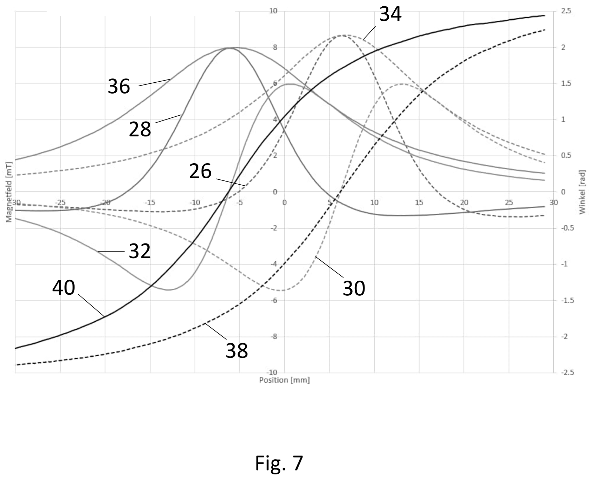

Fig. 7 zeigt die von einem ersten Magnetfeldsensor und einem zweiten Magnetfeldsensor erfassten Magnetfeldstärken in eine X-Richtung, nachfolgend auch $X_1$-Komponente 26 und $X_2$-Komponente 28 genannt, und in eine Y-Richtung, nachfolgend auch $Y_1$-Komponente 30 und $Y_2$-Komponente 32 genannt, welche orthogonal zur X-Richtung ist, für unterschiedliche Positionen eines Gebermagneten 16 sowie die entsprechenden Gesamtbeträge 34, 36 der Magnetstärken und die entsprechenden Winkel 38, 40 zwischen dem jeweiligen Magnetfeldsensor 18 und dem Gebermagneten 16. Bei einer Bewegung der Schweißzange bzw. der Bewegung eines Gebermagneten in Richtung der Sensorachse, d.h. der gedachten Linie durch die beiden Magnetfeldsensoren 18, sind die normierten Magnetfeldverläufe nicht deckungsgleich, was eine Folge der sich verändernden Winkel bzw. des gegenläufigen Magnetfeldverlaufs der orthogonal zueinander gerichteten Feldkomponenten ist. Die $Y_1$-Komponente 30 des Magnetfelds, d.h. die von dem ersten Magnetfeldsensor erfasste Magnetstärke in die zweite Richtung, hat ihr Maximum und damit den Punkt mit der geringsten Steigung im Nulldurchgang, dem Punkt mit der höchsten Steigung der $X_1$-Komponente 26, d.h. der von dem ersten Magnetfeldsensor erfassten Magnetstärke in die erste Richtung. Entsprechend verhält es sich mit den Extrempunkten der $X_2$-Komponente 28, d.h. der von dem zweiten Magnetfeldsensor erfassten Magnetstärke in die erste Richtung, wo die $Y_2$-Komponente 32, d.h. die von dem zweiten Magnetfeldsensor erfasste Magnetstärke in die zweite Richtung, ihren Bereich mit der höchsten Steigung aufweist. Diese gegenläufigen Steigungsbereiche zeigen sich sehr deutlich in den Diagrammen der normierten Magnetfeldverläufe, wo sich deutliche Abweichungen zwischen den einzelnen Magnetfeldverläufen zeigen. In der Fig. 7 ist außerdem ein erster Gesamtbetrag 34 der Magnetstärke des durch den ersten Magnetfeldsensor erfassten Magnetfelds sowie ein zweiter Gesamtbetrag 36 der Magnetstärke des durch den zweiten Magnetfeldsensor erfassten Magnetfelds dargestellt, welche basierend auf den jeweiligen ersten und zweiten Magnetstärken ermittelt werden. Ferner ist ein Verlauf eines ersten Winkels 38 zwischen dem ersten Magnetfeldsensor und dem Gebermagneten 16 und eines zweiten Winkels 40 zwischen dem zweiten Magnetfeldsensor und dem Gebermagneten 16 dargestellt.

**Bezugszeichenliste**

| | |
|---|---|
| 12 | Schweißvorrichtung |
| 14 | Schweißzange |
| 16 | Gebermagnet |
| 18 | Magnetfeldsensor |
| 20 | Steuer- und Auswerteeinheit |
| 22 | Elektrodenarme |
| 24 | Elektroden |
| 26 | $X_1$-Komponente |
| 28 | $X_2$-Komponente |
| 30 | $Y_1$-Komponente |
| 32 | $Y_2$-Komponente |
| 34 | erster Gesamtbetrag |
| 36 | zweiter Gesamtbetrag |
| 38 | erster Winkel |
| 40 | zweiter Winkel |
| 51 | Schweißmaschine |
| 52 | Werkstückträger |
| 53 | Werkstück |

**Patentansprüche**

1. Vorrichtung zur Durchführung einer Arbeitsoperation, insbesondere Schweißvorrichtung (12), umfassend:

   zumindest einen Aktor, der die Arbeitsoperation ausführt;
   eine an dem Aktor befestigte Magnetfeldquelle;
   zumindest einen Magnetfeldsensor (18) zur Erfassung der Position des Aktors, wobei der Magnetfeldsensor (18) ausgebildet ist, eine erste Magnetfeldstärke in eine erste Richtung und eine zweite Magnetfeldstärke in eine zweite, zur ersten Richtung senkrechte Richtung zu erfassen; und
   eine Steuer- und Auswerteeinheit (20), die mit dem Magnetfeldsensor (18) verbunden ist und dazu ausgebildet ist, basierend auf einer Vergleichsmetrik, welche die erfasste erste Magnetfeldstärke in Bezug zu der erfassten zweiten Magnetfeldstärke setzt, zu identifizieren, ob es sich bei dem von dem Magnetfeldsensor (18) erfassten Magnetfeld um ein im Wesentlichen von der Magnetfeldquelle erzeugtes Magnetfeld handelt, und
   bei einer positiven Feststellung basierend auf der erfassten ersten Magnetfeldstärke und/oder der erfassten zweiten Magnetfeldstärke eine Position des Aktors zu ermitteln und basierend auf der ermittelten Position des Aktors eine Steueranweisung auszugeben.

2. Vorrichtung nach Anspruch 1,
wobei die Steuer- und Auswerteeinheit (20) ausgebildet ist, basierend auf der Vergleichsmetrik festzustellen, ob das erfasste Magnetfeld ein Magnetfeld mit räumlich statischem Ursprung oder ein Magnetfeld mit räumlich veränderlichem Ursprung ist, und bei einer Feststellung, dass das Magnetfeld ein Magnetfeld mit räumlich veränderlichem Ursprung ist, das von dem Magnetfeldsensor (18) erfasste Magnetfeld als ein von der Magnetfeldquelle erzeugtes Magnetfeld zu identifizieren.

3. Vorrichtung nach Anspruch 1 oder 2,

wobei die Steuer- und Auswerteeinheit (20) ausgebildet ist, basierend auf der Vergleichsmetrik festzustellen, ob das erfasste Magnetfeld von einem zeitlich statischen Magnetfeld oder von einem zeitlich veränderlichen Magnetfeld ausgeht, und
bei einer Feststellung, dass das erfasste Magnetfeld von einem zeitlich statischen Magnetfeld ausgeht, das von dem Magnetfeldsensor (18) erfasste Magnetfeld als ein von der Magnetfeldquelle erzeugtes Magnetfeld zu identifizieren.

4. Vorrichtung nach einem der vorstehenden Ansprüche,
wobei die Steuer- und Auswerteeinheit (20) ausgebildet ist, basierend auf den Sensordaten des Magnetfeldsensors (18) zu ermitteln, ob der Aktor eine Endposition erreicht hat.

5. Vorrichtung nach einem der vorstehenden Ansprüche,
wobei die Steuer- und Auswerteeinheit (20) ausgebildet ist, die erfasste erste Magnetfeldstärke und die erfasste zweite Magnetfeldstärke auf Basis derselben vorgegebenen Normierungsregel zu normieren, wobei die Vergleichsmetrik die normierte erfasste erste Magnetfeldstärke in Bezug zu der normierten erfassten zweiten Magnetfeldstärke setzt.

6. Vorrichtung nach Anspruch 5,
wobei die Vergleichsmetrik auf einer Differenz zwischen dem größeren Wert aus der normierten erfassten ersten Magnetfeldstärke und der normierten erfassten zweiten Magnetfeldstärke und dem kleineren Wert aus der normierten erfassten ersten Magnetfeldstärke und der normierten erfassten zweiten Magnetfeldstärke basiert.

7. Vorrichtung nach einem der vorstehenden Ansprüche,
wobei die Vorrichtung mehrere, insbesondere zwei, Magnetfeldsensoren (18) umfasst.

8. Vorrichtung nach Anspruch 7,
wobei die Vergleichsmetrik auf der Differenz zwischen der von einem ersten Magnetfeldsensor normierten erfassten ersten Magnetfeldstärke in die erste Richtung und der von einem zweiten Magnetfeldsensor normierten erfassten ersten Magnetfeldstärke in die erste Richtung oder auf der Differenz zwischen der von einem ersten Magnetfeldsensor normierten erfassten zweiten Magnetfeldstärke in die zweite Richtung und der von einem zweiten Magnetfeldsensor normierten erfassten zweiten Magnetfeldstärke in die zweite Richtung basiert.

9. Vorrichtung nach Anspruch 7,
wobei die Vergleichsmetrik auf der Differenz zwischen zwei aus der folgenden Auswahl basiert:

die von dem ersten Magnetfeldsensor normierte erfasste Magnetfeldstärke in die erste Richtung, die von dem ersten Magnetfeldsensor normierte erfasste Magnetfeldstärke in die zweite Richtung, die von dem zweiten Magnetfeldsensor normierte erfasste Magnetfeldstärke in die erste Richtung und
die von dem zweiten Magnetfeldsensor normierte erfasste Magnetfeldstärke in die zweite Richtung,
wobei die Auswahl der zwei Magnetfeldstärken für die Bildung der Differenz basierend darauf erfolgt, welche der normierten erfassten Magnetfeldstärken für den Erfassungszeitraum die größte Differenz zwischen Minimalwert und Maximalwert aufweisen,
wobei der Minimalwert der über den Erfassungszeitraum kleinste ermittelte Wert für die jeweilige Magnetfeldstärke ist und der Maximalwert der über den Erfassungszeitraum größte ermittelte Wert für die jeweilige Magnetfeldstärke ist.

10. Verfahren zur Durchführung einer Arbeitsoperation, insbesondere eines Schweißvorgangs, wobei das Verfahren umfasst:

von zumindest einem Magnetfeldsensor (18) zur Erfassung der Position zumindest eines Aktors, an dem eine Magnetfeldquelle befestigt ist, eine erste Magnetfeldstärke in eine erste Richtung und zweite Magnetfeldstärke in eine zweite, zur ersten Richtung senkrechten Richtung erfasst wird,

von einer Steuer- und Auswerteeinheit (20), die mit dem Magnetfeldsensor (18) verbunden ist, basierend auf einer Vergleichsmetrik, welche die erfasste erste Magnetfeldstärke in Bezug zu der erfassten zweiten Magnetfeldstärke setzt, identifiziert wird, ob es sich bei dem von dem Magnetfeldsensor (18) erfassten Magnetfeld um ein von der Magnetfeldquelle erzeugtes Magnetfeld handelt, und

bei einer positiven Feststellung basierend auf der erfassten ersten Magnetfeldstärke und/oder der erfassten zweiten Magnetfeldstärke eine Position des Aktors ermittelt wird und basierend auf der ermittelten Position des Aktors eine Steueranweisung ausgegeben wird.

Fig. 1

EP 4 726 332 A2

Fig. 2

Fig. 3

Fig. 4

Fig. 5

Fig. 6

Fig. 7